# FASCICULE DE BREVET EUROPEEN

(11) **EP 1 678 754 B1**
(45) Date de publication et mention de la délivrance du brevet: **15.07.2015**
(21) Numéro de dépôt: 04805334.2
(22) Date de dépôt: 28.10.2004
(51) Int. Cl.: H01L 21/762

(54) **PROCEDE DE TRANSFERT AUTO-ENTRETENU D'UNE COUCHE FINE PAR IMPULSION APRES IMPLANTATION OU CO-IMPLANTATION**
VERFAHREN ZUM SELBSTUNTERSTÜTZTEN TRANSFER EINER FEINEN SCHICHT DURCH PULSATION NACH IMPLANTIERUNG ODER COIMPLANTIERUNG
METHOD FOR SELF- SUPPORTED TRANSFER OF A FINE LAYER BY PULSATION AFTER IMPLANTATION OR CO-IMPLANTATION

(30) Priorité: 28.10.2003 FR 0312621
(43) Date de publication de la demande: 12.07.2006
(73) Titulaire: Soitec, 38190 Bernin (FR); Commissariat à l'Énergie Atomique et aux Énergies Alternatives, 75015 Paris (FR)
(72) Inventeur: NGUYEN, Nguyet-Phuong, F-38100 Grenoble, (FR); CAYREFOURCQ, Ian, F-38330 Saint Nazaire les Eymes (FR); LAGAHE-BLANCHARD, Christelle, F-38134 Saint Joseph de Riviere (FR); BOURDELLE, Konstantin, F-38930 Crolles (FR); TAUZIN, Aurélie, F-38000 Grenoble (FR); FOURNEL, Franck, F-38430 Moirans (FR)
(74) Mandataire: Regimbeau
(86) Numéro de dépôt international: PCT/FR2004/002779
(87) Numéro de publication internationale: WO 2005/043615

(56) Documents cités:
- EP-A- 0 994 503
- WO-A-00/63965
- US-A1- 2002 025 604
- US-A1- 2003 077 885
- US-B1- 6 593 212
- AGARWAL A ET AL: "EFFICIENT PRODUCTION OF SILICON-ON-INSULATOR FILMS BY CO- IMPLANTATION OF HE+ WITH H+" APPLIED PHYSICS LETTERS, AMERICAN INSTITUTE OF PHYSICS. NEW YORK, US, vol. 72, no. 9, 2 mars 1998 (1998-03-02), pages 1086-1088, XP000742819 ISSN: 0003-6951

## Description

### Domaine de l'invention

L'invention concerne un procédé de transfert d'une couche ultra-fine (on parle aussi de couche mince ou ultra-mince) mettant en oeuvre la propagation autoentretenue d'une fracture initiée par une impulsion d'énergie. Elle trouve des applications en particulier dans les domaines de la microélectronique, de la micro-mécanique, de l'optique et de l'électronique intégrée.

### Etat de la technique

Ainsi qu'on le sait, le détachement d'une couche mince peut être obtenu par implantation d'espèces chimiques dans un substrat source, par exemple en silicium, pour induire la formation d'une zone de défauts à une certaine profondeur. Ces défauts peuvent être des micro-bulles et/ou des platelets et/ou des micro-cavités et/ou des boucles de dislocations et/ou d'autres défauts cristallins, perturbant localement la qualité cristalline du matériau ; leur nature, leur densité et leur taille dépendent beaucoup de l'espèce implantée (de l'hydrogène, typiquement) ainsi que de la nature du substrat source. Un traitement thermique peut ensuite être appliqué pour permettre le développement des défauts spécifiques présents dans la zone fragilisée, ce qui permet d'obtenir le détachement ultérieur de la couche mince du substrat source,. Ceci a notamment été décrit dans le document US-5 374 564 et ses développements, dont les documents WO 00/63965 et US-6 020 252.

Toutefois un détachement spontané pendant un recuit thermique est parfois mal adapté à certaines situations, par exemple lorsque les substrats mis en contact ont des coefficients de dilatation thermique différents. Par ailleurs on sait (voir par exemple US - 2003/0134489) que, dans le cas d'une fracture obtenue thermiquement, et dans certaines conditions, celle-ci commence préférentiellement en un endroit localisé de la plaque, ce qui peut parfois conduire à des inhomogénéités de surface qui se traduisent sous la forme d'une apparence de type « marbrure ». Ces inégalités apparaissent également dans le cas d'une fracture purement thermique lorsqu'on cherche à surfragiliser en implantant en surdose une espèce telle que l'hydrogène de manière à en faciliter la fracture ou minimiser le budget thermique (couple température-durée) apporté ensuite aux plaques.

Lorsque le détachement est réalisé à haute température (typiquement vers 500°C environ), parmi les problèmes technologiques parfois rencontrés, il faut citer la rugosité de la surface ainsi que la dégradation de la couche transférée au cours du détachement thermique. Cela rend plus difficiles les é tapes suivantes de t raitement (par exemple : il faut polir p lus la c ouche transférée, des défauts cristallins risquent d'être créés pendant les traitements suivants, ...). De plus, dans les hétéro-structures (comportant une superposition de substrats en matériaux différents), un autre problème technologique rencontré est la présence d'un champ de contraintes très fort dans les diverses couches en contact, au cours du traitement thermique, en raison de la différence des coefficients de dilatation thermique des divers matériaux mis en contact. Cela peut induire la dégradation des hétéro-structures si le détachement thermique s'opère à une température plus haute qu'une température critique. Cette dégradation peut être, typiquement, la casse d'un ou des deux substrats mis en contact et/ou le décollement des substrats au niveau de l'interface de collage.

C'est pourquoi il peut être souhaité d'obtenir le détachement à plus basse température.

Une façon d'obtenir ce type de détachement est de "jouer" avec les conditions d'implantation. Par exemple, un surdosage de l'espèce implantée permet d'augmenter la fragilisation de la zone implantée et de provoquer le détachement à basse température par l'apport d'une force extérieure.

Le détachement peut aussi se faire en appliquant, généralement suite au traitement thermique, une force extérieure qui provoque la fracture dans la zone fragilisée jusqu'au détachement de la couche mince. On peut notamment se référer au document US - 6 225 192 (CEA).

Il est important de noter que, pour un substrat donné et des conditions d'implantation données, ce n'est pas uniquement la température de traitement qui conditionne les conditions ultérieures de détachement de la couche mince, mais aussi la durée de ce traitement, ce qui s'est traduit par la notion de budget thermique (voir FR-2 767 416 - CEA) ; quant à l'apport d'énergie mécanique, il est par exemple appliqué par un outil de type "guillotine" (voir WO 02/083387 - SOITEC).

C'est ainsi que Henttinen et al. (2000) [1] ont montré que, si le substrat source est une plaque de silicium, une dose d'ions d'hydrogène implantés de 1.10¹⁷ H⁺/cm² (soit 5.10¹⁶ H₂/cm²) permet le détachement par une force mécanique, après réalisation des étapes suivantes : traitement, de même que le substrat cible, par une activation chimique de plasma ; nettoyage de type RCA1, collage à température ambiante du substrat source sur le substrat cible, et recuit à 200°C pendant 2h. La force mécanique utilisée provenait d'une lame insérée à l'interface collé pour initier le détachement.

Cette approche, bien que diminuant la rugosité de la surface transférée (de l'ordre de la moitié par rapport aux solutions classiques de détachement, purement thermiques et sans activation plasma), implique une propagation lente et par à coups de l'onde de fracture. Ainsi Henttinen rapporte que chaque avancée de lame entraîne la propagation d'une fracture qui se stabilise sur une certaine distance au bout de deux minutes.

Ce type de détachement mécanique consiste donc à introduire une lame depuis les bords de la structure et à avancer cette lame sur la quasi-totalité de la structure collée, comme pour la " découper" le long de la zone fragilisée ; on parle parfois de détachement assisté, puisque le rôle de l'outil (tel qu'une lame) est de propager l'onde de fracture d'un bord à l'autre de la structure.

Ce type de fracture amène les défauts suivants, au niveau de la future surface dégagée par le détachement de la couche mince :
- défaut de couronne (zone non transférée, à la périphérie du produit final), par exemple lié à une énergie de collage local trop faible par rapport au reste de l'interface, et à l'introduction des outils pour entamer le transfert,
- non uniformité (rugosité à basse fréquence) de l'épaisseur de la couche mince transférée, notamment en raison de l'onde de fracture assistée mécaniquement, donc irrégulière, par à coups, ce qui nécessite ensuite des traitements, tels qu'un polissage, que l'on cherche pourtant à éviter de manière générale,
- difficile déploiement industriel, compte tenu de l'utilisation d'un outil qui accompagne la propagation de la fracture, ce qui implique un traitement individuel de chaque structure (ou plaque).

Par ailleurs, on a constaté que, si le budget thermique est trop faible, le transfert de la couche mince est de mauvaise qualité, tandis que s'il est trop élevé, il peut y avoir fracture de l'un des substrats dans le cas d'une hétéro-structure. On comprend donc qu'il existe en principe une fenêtre étroite pour les paramètres opératoires (bien entendu liée aux conditions, notamment les doses implantées, la nature des matériaux, les températures de recuit, ...), or cette étroitesse constitue une contrainte lourde pour une exploitation industrielle.

La plupart de ces inconvénients se retrouve dans le cas du détachement d'une c ouche mince d ans u n substrat homogène (avec un seul matériau constitutif, SOI, par exemple).

Le détachement de la couche mince est bien sûr également conditionné par le choix des espèces chimiques implantées.

Il a été indiqué ci-dessus qu'on implante généralement de l'hydrogène, mais d'autres options ont été proposées, notamment en implantant de l'hélium.

Il peut même y avoir combinaison de deux espèces chimiques différentes.

C'est ainsi que Agarwal et al. (1998) [2] ont constaté que le fait d'implanter à la fois de l'hydrogène et de l'hélium permettait de réduire la dose totale d'ions implantés, en raison semble t'il de rôles différents joués par l'hydrogène et par l'hélium : l'hydrogène interagit avec les liaisons Si-Si brisées par l'implantation, pour créer des liaisons Si-H, ce qui aboutit à une grande densité de défauts de type platelets d'une taille de l'ordre de 3-10 nm (appelés H-défauts, de type platelet), tandis que l'hélium, qui n'agit pas chimiquement, conduit à l'apparition d'une moindre densité de défauts plus grands (taille supérieure à 300 nm environ). Les traitements thermiques envisagés dans cet article sont de 450°C pendant 20 mn ou de 750°C pendant 20s, ce qui implique nécessairement les inconvénients précités à propos du détachement à haute température.

Cette combinaison hydrogène-hélium a aussi été étudiée, de manière plus théorique, par Cerofolini et al. (2000) [3], qui ont noté que la mise sous pression des défauts était plus forte avec l'implantation de l'hélium qu'avec celle de l'hydrogène, et que le traitement thermique pouvait avoir des effets différents selon la température choisie : un recuit entre 150°C-250°C provoque une diminution du nombre de liaisons Si-H, un recuit dans la gamme 300°C-450°C provoque au contraire une augmentation de ce nombre, tandis qu'un recuit au-delà de 550°C tend plutôt à faire diminuer à nouveau ce nombre. Mais cet article n'en déduit pas de conclusions pratiques quant à la manière d'obtenir des couches minces de bonne qualité (notamment du point état de surface) pour un coût modéré.

L'invention a pour objet de pallier les inconvénients précités.

Plus précisément, l'invention a pour objet un procédé de transfert d'une couche mince pouvant être réalisé à basse température (afin de limiter les fortes contraintes mécaniques en cas d'utilisation de matériaux présentant de grandes différences de coefficients de dilatation), pouvant être réalisé de façons collectives et limitant les défauts précédemment cités lors du détachement de la couche mince, en évitant notamment les à coups de l'onde de fracture. En d'autres termes, l'invention vise à obtenir, pour un coût modéré, des couches minces de grande qualité, en évitant donc, à la fois les inconvénients d'un traitement thermique à haute température et ceux liés à l'usage d'un outil pour un détachement assisté, et ceux liés à un traitement additionnel pour diminuer la rugosité après détachement.

### Présentation de l'invention

L'invention propose à cet effet un procédé de transfert auto-entretenu d'une couche fine tel que décrit dans la revendication 1.

On peut définir ici un détachement auto-entretenu comme étant un détachement complet et quasi-instantané, analogue à celui obtenu par un simple traitement thermique à haute température, mais provoqué par un éventuel outil sans que celui-ci ait à suivre une quelconque onde de fracture (s'il y a un outil, il vient donc au plus en contact avec le substrat et la couche, sans longer l'interface de détachement) ; c'est donc, en d'autres termes, le contraire d'un détachement assisté. On peut aussi parler de phénomène « catastrophique ».

De manière préférée, on peut réaliser une co-implantation de deux espèces, par exemple de l'hydrogène et de l'hélium, telle que décrite dans la demande FR2847075 ou la demande WO-04/044976 ; l'implantation de plusieurs espèces peut être concomitante ou non.

La température de traitement thermique est avantageusement choisie en sorte de favoriser le développement de défauts cristallins dans la zone fragilisée sans pour autant induire de détachement spontané thermique. Cette température sera suffisamment basse pour ne pas générer des contraintes mécaniques trop importantes dans le substrat dans l'hypothèse où le substrat source et/ou un éventuel substrat cible comporteraient des matériaux présentant des coefficients de dilatation très différents. C'est pourquoi le procédé est un procédé de transfert se produisant à une température relativement basse (pas plus de 500°C dans le cas d'une hétéro structure Silicium/Quartz par exemple).

Selon l'invention, la fracture est obtenue par propagation d'une onde de fracture auto entretenue, après que celle-ci a été initiée par une impulsion d'énergie appliquée au niveau d'une zone fragile (cette impulsion pouvant être locale ou globale). Pour obtenir ce phénomène, des conditions d'implantation (dose, énergie, nature de l'espèce (ou des espèces), courant, ordre des implantations (s'il y en a plusieurs) et positions relatives dans la profondeur du substrat des espèces implantées (dans le cas d'une implantation de plusieurs espèces), température d'implantation, etc...) et de traitement adapté (par exemple un traitement thermique) semblent permettre de mettre en forme la distribution, la morphologie, la taille des défauts cristallins (cavités, platelets, micro et macro bulles et autres types de défauts) qui forment la zone fragile. C'est précisément le travail de mise en forme particulière de la zone fragile qui semble permettre d'obtenir le résultat de fracture auto entretenue.

L'invention consiste à favoriser les conditions de fragilisation proche, dans leur nature, des conditions obtenues lors de la fracture thermique, sans toutefois les conduire jusqu'à ce point. Le complément d'énergie est alors fourni par complément impulsionnel au terme ou durant le traitement thermique, et induit la propagation d'une fracture autoentretenue.

Par propagation auto entretenue de l'onde de fracture, il est entendu qu'il n'est pas nécessaire d'assister la propagation de l'onde en faisant avancer un outil ou en répétant l'impulsion d'énergie d'initiation. Et une caractéristique importante de l'invention est que l'onde de fracture est propagée sur toute la surface de la plaque en moins de 1 seconde, voire de l'ordre de la milliseconde (vitesses supérieurs à 100m/sec) pour des diamètres jusqu'à 300mm.

Une origine possible de la fracture autoentretenue (ou catastrophique) vient de la nature des défauts enterrés. Les études menées (dans le Germanium, mais applicable au Silicium) ont montré que dans les conditions de fracture autoentretenue la densité de défauts (micro-fissures, cavités, platelets, micro et macro bulles, ...) est estimée entre 0,03 et 0, 035 par micron carré, leurs tailles sont de l'ordre de 7 à 8 microns carrés, et la surface ouverte par ces défauts par rapport à la surface totale de la plaque est estimée entre 25 et 32 %. C es valeurs caractéristiques de la zone fragilisée peuvent paraître similaires à des valeurs caractéristiques constatées lorsque la fracture est obtenue thermiquement, mais diffèrent de celles obtenue après un traitement de fragilisation qui nécessite une fracture mécanique assistée (auquel cas, la valeur de surface ouverte est plutôt de l'ordre de 10%).

De manière préférée, au moins la condition précitée sur la surface ouverte est réalisée (elle semble être la plus importante ; elle semble pouvoir être généralisée à une plage de 20% à 35%), éventuellement complétée par l'une et/ou l'autre des conditions sur la densité ou la taille des défauts.

Bien entendu d'autres effets ou causes ne sont pas exclus par cette interprétation, en particulier la nature chimique des liaisons dans le substrat peut également favoriser l'apparition du phénomène d'onde d e fracture auto-entretenue.

En d'autres termes, l'invention semble consister à favoriser les conditions de fragilisation proche, dans leur nature, des conditions obtenues lors de la fracture thermique, sans toutefois les conduire jusqu'à ce point. Le complément d'énergie est alors fourni par complément impulsionnel.

Il faut souligner qu'il n'était pas évident pour l'homme du métier d'arriver à de telles conditions permettant de produire une fracture auto-entretenue, même si ce résultat pouvait paraître en soi extrêmement souhaitable.

L'homme de métier, cherchant à améliorer les résultats de fracture mécanique aurait pu être incité à fragiliser davantage le substrat en augmentant par exemple le budget thermique apporté à la structure implantée et collée au substrat raidisseur. Et l'homme de l'art aurait pu vérifier qu'effectivement, en augmentant c e budget thermique, l'effort nécessaire pour propager l'onde d e collage était moindre. Toutefois, il n'aurait pu observer le phénomène d'onde de fracture auto-propagée, qui ne se produit, comme on le verra par la suite, que dans des conditions particulièrement favorables. En particulier, l'homme du métier n'aurait pas cherché à poursuivre la fragilisation jusqu'à un point idéal qui précéderait le moment de la fracture thermique, car dans des conditions générales d'implantation et de traitement thermique, il s'agit d'un point instable qu'il serait dangereux ou vain de vouloir atteindre. En particulier dans le cas de la fabrication des hétéro-structures, le franchissement de ce point instable, et donc la fracture thermique du substrat, conduit bien souvent à une casse complète du produit final lié au relâchement soudain, lors de la fracture, des contraintes d'origine thermomécanique emmagasinées dans les substrats collés.

Ainsi, et tout au plus, l'homme du métier se serait attendu à ce que l'effort continu nécessaire pour propager l'onde de fracture soit moindre. Il n'avait donc, notamment, a ucune raison objective pour penser que le simple prolongement du recuit de fragilisation (par rapport à l'art antérieur) suivi de l'application d'un effort impulsionnel conduise à une onde de fracture auto-entretenue.

En fait, l'application d'énergie impulsionnelle peut être globale (choc thermique, ultra son, ..) ou localisée (laser, choc mécanique, effort de traction, ...).

De manière préférée, cette impulsion est localisée, avantageusement appliquée par un outil animé d'un mouvement bref et de faible amplitude. Cet apport d'énergie est avantageusement appliqué à proximité immédiate de la couche enterrée, limité à une partie seulement de celle- ci, de préférence à une portion périphérique de celle-ci.

Cette impulsion peut aussi être notamment constituée d'un apport thermique localisé (par exemple appliqué par une impulsion laser) ou d'une contrainte extérieure (par exemple à proximité immédiate de la zone fragilisée, en un bord de celle-ci).

Pour des raisons de simplicité de mise en oeuvre, la fracture est obtenue à la température ambiante entre 0 et 50°C, par exemple par application d'un choc mécanique localisé en bordure de l'ensemble.

Il a été observé que l'impulsion d'énergie avait toute son efficacité pour initier l'onde de fracture quand celle-ci conduisait à une ouverture très localisée de l'interface au niveau de la couche fragile. Ainsi un choc fourni par un outil de type lame, ou plus généralement tout effort de type traction, induit la propagation d'une fracture autoentretenue de manière très efficace.

Lorsque le traitement complémentaire est réalisé sous la forme d e l'apport d'un budget thermique, celui ci est inférieur au budget thermique nécessaire pour l'obtention de la fracture.

L'état de surface du substrat formé après fracture présente des rugosités haute et basse fréquences améliorées par rapport à l'art antérieur. Ce résultat est particulièrement prononcé pour les basses fréquences avec notamment l'absence des ondes de fracture. On suppose que ce résultat est lié au fait que, dans le cadre de l'invention, l'onde de fracture se propage de façon continue, sans à coups et au sein d'une couche très fragilisée (ce qui faciliterait la propagation de l'onde suivant une zone préférentielle au sein de la couche fragilisée), par rapport à ce qui est obtenu dans l'art antérieur.

Dans des conditions d'implantation standard (implantation d'H⁺ de l'ordre de 5.10¹⁶ at/cm² entre 20 et 300 keV dans du silicium - Si) le phénomène de fracture auto entretenu ne s'observe que pour des points de fonctionnement étroits, qu'il peut être difficile de reproduire de manière systématique.

Par contre, dans des conditions différentes, particulière, la fenêtre opératoire pour obtention du phénomène de fracture auto-entretenue est large, ce qui signifie que ce phénomène est observable pour une large variation des paramètres d'obtention de la couche fragiles (paramètres d'implantation et du traitement thermique additionnel, en particulier). C'est par exemple le cas, lorsque l'implantation est une co-implantation dans des conditions définies (voir ci-dessous), et/ou lorsque le profil en température du traitement additionnel comprend des phases adaptées. Dans le cadre d'une exploitation industrielle, il est important d'assurer la robustesse du procédé vis à vis des dérives, imprécisions, et variations des paramètres opératoires qui sont bien entendu inévitables. Pratiquement, cette grande robustesse autorise l'exploitation du procédé par lot de plaques, plutôt que plaque après plaque, comme cela est courant dans l'industrie de la micro électronique. Ainsi on a pu vérifier qu'il était possible d'obtenir la fracture sur un lot de plaques (25 plaques) à l'aide d'un outil de manipulation de plaque tel que celui divulgué dans WO03013815. Il a également été noté que le temps nécessaire à la mise en oeuvre du procédé correspond sensiblement au temps de mise en oeuvre des procédés de l'art antérieur.

En d'autres termes, selon un aspect particulier de l'invention, celle-ci propose un procédé de fabrication d'un lot de substrats comportant des étapes suivantes :
- implantation de chacun des substrats,
- traitement de fragilisation, en lot, des substrats,
- application d'impulsions d'énergie simultanément à chacun des substrats, (traitement collectif).

Il semble devoir être noté que, selon l'invention, le substrat est fragilisé et l' « énergie » de fragilisation n'a pas besoin d'être maintenue jusqu'au moment de l'application de l'impulsion énergétique. On peut même ajouter que provoquer une propagation auto-entretenue à chaud n'est pas recommandée dans le cas des hétéro structures, car les contraintes issues des différences de coefficient de dilatation thermique, qui se libèrent lors de la fracture, pourraient amener à la casse des substrats.

Il mérite d'être souligné que, selon l'invention, dans certaines conditions d'implantation, on parvient à fragiliser très fortement la zone implantée sans générer de détachement purement thermique, et cela même pour des temps de recuit très importants (pas de détachement observé après 24h de recuit à basse température définie ci-dessous) ; par contre, le détachement se déclenche de manière autoentretenue, par simple apport d'énergie impulsionel (tel qu'un choc mécanique au niveau de l'interface fragilisé, par exemple).

Les conséquences en sont significatives :
- la fenêtre opératoire de l'étape de recuit peut être très grande : la borne maximum pour la durée de ce recuit de pré-fragilisation est fortement repoussée (voire n'existe plus); cela est tout à fait favorable à l'industrialisation du procédé,
- il n'y a pas de détachement assisté puisque la fracture auto-entretenue permet de propager l'onde de fracture instantanément et s ans à-coups sur toute la surface de la plaque ; il n'est pas nécessaire qu'une quelconque lame pénètre entre le substrat et la future couche mince, ce qui évite l'endommagement de la couche transférée par l'outil de décollement. La fracture auto-entrenue améliore aussi nettement la topologie des surfaces ainsi dégagées (avec par exemple une rugosité plus faible (surtout en basse fréquence)), et évite les défauts de couronne, ce qui rend utilisable la totalité de la couche mince, y compris sa périphérie
- le fait de ne plus avoir à introduire d'outil est aussi favorable à l'industrialisation du procédé et à un traitement collectif des substrats par lots de plaque.

Dans la mesure où, au plus tard au moment du traitement thermique, on met le substrat source en contact intime par ladite face à un raidisseur ou substrat cible, le traitement thermique contribue à améliorer l'énergie de collage entre ces substrats.

Ce substrat cible ou raidisseur est avantageusement choisi parmi les matériaux monocristallins ou polycristallins, comme le silicium ou le saphir notamment, ou sous la forme d'un matériau amorphe, comme par exemple sous la forme de silice fondue.

Selon une caractéristique particulièrement avantageuse de l'invention, on effectue une implantation de plusieurs espèces de façons concomitantes ou non. Avantageusement, il peut s'agir d'une co-implantation d'hydrogène et d'hélium.

De manière avantageuse, dans le cas du silicium, dans le cas d'une co-implantation hydrogène-hélium, on peut implanter l'hydrogène (de préférence sous forme H⁺) avec une dose relativement basse (typiquement de l'ordre de quelques 10¹⁶ H/cm²), étant rappelé que l'hydrogène montre une efficacité importante pour créer une couche de fragilisation. Au niveau de cette couche, l'hélium peut être implanté avec une dose relativement basse (typiquement de l'ordre de 10¹⁶ He/cm², ou de quelques 10¹⁶ He/cm²).

Lorsque le substrat source a été collé à un substrat cible, le traitement thermique à basse température (néanmoins suffisante pour obtenir une bonne solidité des interfaces du collage), a pour effet de permettre le détachement d'une couche ultra-fine très peu rugueuse (de l'ordre de quelques nm), i nitié par u ne i mpulsion extérieure. L'avantage de la co-implantation est d'obtenir la fragilisation maximum de cette zone à la température suffisante pour la solidité des interfaces du collage sans pour autant devoir atteindre des températures trop hautes que des hétérostructures ne pourraient peut être pas supporter et sans être non plus obligé d'utiliser de très fortes doses d'implantation (ce qui est un moyen connue de limiter la valeur de la température nécessaire au développement de la zone fragilisée).

De manière avantageuse, les deux espèces sont implantées au même niveau mais u ne variante consiste à décaler les profils d'implantation. Les deux espèces peuvent être implantées dans n'importe quel ordre, mais de manière avantageuse, dans le cas d'un substrat de silicium et d'une co-implantation hydrogène-hélium, il est préférable d'implanter le profil le plus profond en premier.

En fait, au moins lorsqu'on procède à une co-implantation hydrogène-hélium dans un substrat de silicium, on peut choisir une température de traitement thermique de 200°C à 400°C.

De manière préférée, le substrat source est en un matériau choisi par les semi-conducteurs et les isolants, monocristallins, polycristallins ou amorphes. C'est ainsi qu'il peut être choisi par les semi-conducteurs IV ; un exemple particulièrement intéressant est le silicium mais il peut aussi s'agir de germanium ou d'alliages Si-Ge. Il peut aussi s'agir de matériaux de la famille de III-iV ou des II-Vi comme l'As-Ga ou l'InP ou en un matériau isolant comme les matériaux ferroélectriques, par exemple le LiNbO3 et Li TaO3.

Le t raitement thermique p eut également présenter un profil adapté de manière à réduire le temps de ce traitement, comme cela est par exemple divulgué dans la demande de brevet européen 02-293049 déposée le 10 décembre 2002.

En fait, la gamme de température dépend principalement de la nature de l'espéce (ou des espèces) implantée(s) et de la nature du matériau constitutif du substrat source ainsi que la nature du substrat raidisseur notamment dans le cas d'une hétérostructure.

### Description générale

Des objets, caractéristiques et avantages de l'invention ressortent de la description qui suit, donnée à titre illustratif non limitatif en regard du dessin annexé, sur lequel :
- la figure 1 est une vue schématique d'un substrat source en cours d'implantation,
- la figure 2 en est une vue ultérieure après mise en contact intime (collage) à un substrat cible, et
- la figure 3 en est une vue en cours de détachement d'une couche fine issue du substrat source.

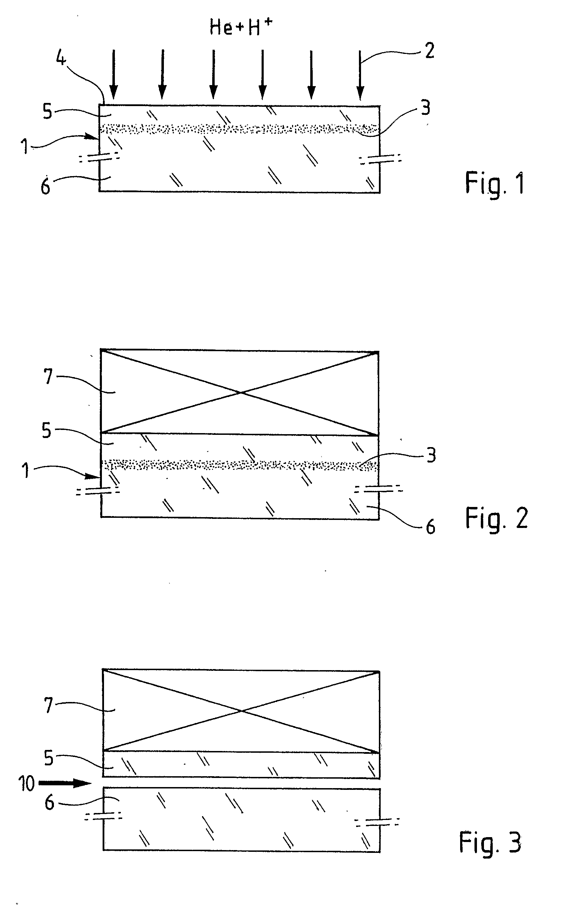

La figure 1 représente ainsi un substrat 1, par exemple en silicium avantageusement oxydé à sa surface 4, en train d'être soumis à un traitement d'implantation, schématisé par les flèches 2, par exemple par bombardement, d'ions ou d'espèces gazeuses.

Cette implantation implique, à une profondeur donnée, l'implantation d'une première espèce qui est apte à générer des défauts, par exemple de l'hydrogène, de préférence sous la forme d'ions H+. Dans un exemple préféré de mise en oeuvre de l'invention, cette implantation peut être une co-implantation de deux espèces, par exemple Hydrogène - Hélium. Dans le cas représenté, les deux espèces sont implantées à la même profondeur, mais en variante, il est préférable que la première espèce implantée soit celle dont le profil est le plus profond, par exemple l'hélium avant l'hydrogène.

En effet, on peut commencer par l'implantation de la première espèce, à savoir l'hydrogène, suite à quoi l'hélium peut être implanté. Toutefois l'ordre inverse des implantations peut être préférable, même si les deux implantations ne se font pas à la même profondeur.

Il en résulte une zone enterrée 3 fragilisée par la présence de défauts.

Cette zone fragilisée 3 délimite, au sein du substrat source, une future couche mince 5 et un reste de substrat source 6, c'est à dire ce qui restera du substrat source après détachement de la couche mince ; ce reste pourra servir de substrat source pour un nouveau cycle de mise en oeuvre du procédé.

La figure 2 représente une étape au cours de laquelle on met le substrat source, contenant la zone enterrée fragilisée 3, par sa face 4, en contact intime avec une face correspondante d'un substrat cible 7, typiquement par collage moléculaire direct, dont la fonction est celle d'un raidisseur.

On applique alors un traitement thermique qui va, d'une part, permettre un développement de la fragilisation de la couche enterrée 3, et d'autre part, lorsqu'une étape de collage a eu lieu, permettre une consolidation des liaisons de collage entre substrat source et substrat cible.

Plus précisément, la température de ce traitement thermique est choisie dans une gamme de températures propres à développer la zone fragilisée.

Ce traitement est avantageusement conduit à une température choisie dans la gamme 200°C-400°C, de préférence dans la gamme 300°C-350°C, pendant une durée typiquement choisie de quelques heures, par exemple 2 heures. Ainsi, les budgets thermiques (couples température-durée) sont industriellement réalistes.

A la figure 3 est représentée l'étape de détachement de la couche mince 3 vis-à-vis du reste du substrat source, au moyen de l'application d'un apport impulsionel d'énergie, de préférence bref et d'amplitude limitée, par exemple sous la forme d'un choc ou d'une impulsion.

Il est par exemple constitué d'une contrainte mécanique schématisée par la flèche 10.

Le détachement obtenu est auto-entretenu en ce sens, notamment, qu'il n'y a pas de mouvement d'un outil le long de la couche fragilisée.

Cet apport localisé d'énergie est ici limité à une partie de la couche enterrée, schématisé sous la forme d'un effet de coin correspondant à un choc appliqué par un outil tel qu'une lame sur (ou à proximité d') une portion de cette couche enterrée fragilisée ; mais il peut être de toute autre nature, par exemple un couple parallèle au plan de la zone enterrée fragilisée avantageusement appliqué sous la forme d'une impulsion de faible amplitude angulaire. Grâce au procédé de l'invention, la face de la couche mince qui est libérée par le détachement auto-entretenu dans la zone enterrée fragilisée (en pratique sensiblement plane) présente une rugosité bien plus faible que selon les solutions classiques, sans qu'il ait été nécessaire de prévoir un traitement particulier de la surfaces transférée ni de polissage important (« grossier ») après détachement. Il mérite d'être noté que, puisque le détachement est auto-entretenu, il n'y a pas de réelle propagation par à-coups d'une onde de fracture susceptible de générer des ondulations en surface, et que, puisqu'il n'y a pas de mouvement d'un quelconque outil le long des surfaces nouvellement créées (ou de mouvement relatif entre les deux parties de part et d'autre de la couche enterrée) il n'y a pas de dégradation des surfaces ainsi libérées, qui ont donc l'état de surface, très lisse, provoqué par le détachement auto-entretenu.

Le substrat source 1 peut être non seulement en silicium, mais plus généralement en tout matériau connu approprié, par exemple semi-conducteur IV, III-V ou II-Vi, ferroélectrique, monocristallin ou polycristallin, voire amorphe. C'est ainsi que ce substrat source peut être :
- un autre semi-conducteur de la colonne IV du tableau périodique des éléments, par exemple en germanium,
- un semi-conducteur du type III-V ou II-VI tel que AsGa ou InP, notamment,
- un isolant par exemple du type niobate ou tantalate, tels que LiNbO3 ou LiTaO3, notamment.

Quant au substrat cible il peut être réalisé dans une grande variété de matériaux, à choisir selon les besoins, monocristallin ou polycristallin (par exemple semi-conducteurs, par exemple parmi les mêmes matériaux que pour le substrat source) voire amorphe (par exemple verres ou polymères) ; c'est ainsi qu'il peut notamment être :
- un matériau cristallin tel que le saphir,
- en silice fondue ou en un autre verre,
- une simple couche de rigidification, par exemple un oxyde de quelques microns d'épaisseur, déposée par toute technique connue appropriée (cela ne correspond plus, il est vrai, à un substrat cible massif du type représenté sur les dessins).

Il mérite d'être noté que le substrat cible peut n'être qu'un substrat intermédiaire dont la couche mince est ensuite transférée sur un substrat final.

### Exemples

### Co-implantation

Selon un premier exemple de réalisation ne faisant pas partie de l'invention, un substrat de Si (-700µm) comportant une couche de SiO₂ thermique en surface (par exemple 145nm) peut être implanté dans un premier temps avec des atomes d'hélium dans les conditions d'implantation 70keV - 10¹⁶He/cm², puis implanté avec des atomes d'hydrogène dans les conditions d'implantation 30keV-4,25.10¹⁶H/cm². On réalise ainsi l'implantation du profil le plus profond en premier. Ce substrat source peut ensuite être solidarisé sur un substrat cible de Si(-700µm) par collage moléculaire. Un traitement thermique autour de 350°C pendant un certain temps (2h par exemple) est ensuite appliqué à la structure. Si le traitement thermique est adapté, comme par exemple divulgué dans la demande de brevet européen 02-293049, la fenêtre d'obtention du phénomène de fracture auto-entretenu est de l'ordre de quelques heures (soit un recuit de fragilisation compris entre 2 et 6 heures). Ensuite, avec à peine un début d'insertion d'une lame entre les interfaces de collage sous la forme d'un choc, le détachement auto-entretenu au niveau du maximum de concentration d'hydrogène mène au report de la couche mince de Si sur le substrat cible. C'est a insi que ces essais avec une co-implantation d'hydrogène et d'hélium dans le substrat-source dans les conditions de l'invention ont conduit à un détachement auto-entretenu, c'est-à-dire un détachement complet et quasi-instantané, avec une propagation continue et plane de l'onde de fracture, auto-entretenue, initiée à l'aide d'un apport d'énergie impulsionnel, ce qui a eu notamment pour avantage d'éviter les ondulations en surface, c'est-à-dire d'éviter les variations importantes de rugosité de surface après fracture, par comparaison avec un détachement progressif. De ce fait, ce détachement impulsionnel implique ensuite un moindre polissage.

La rugosité de la surface transférée mesurée à haute fréquence (en microscopie à force atomique), de l'ordre de 45 à 50 Angstrôms RMS, et à basse fréquence (par profilométrie mécanique), de l'ordre de 10 Angstrôms RMS, de cette surface transférée sont bien inférieures à celles qui peuvent être obtenues dans le cas de H-implanté seul (32keV-5,5.10¹⁶H/cm²) suivi d'un traitement thermique à 500° C (rugosité à haute fréquence de l'ordre de 75 Angstrôms RMS et rugosité à basse fréquence de l'ordre de 26 Angstrôms RMS).

Selon un exemple de réalisation de l'invention, un substrat de Si (environ 700µm) comportant une couche de SiO₂ thermique en surface (par exemple 200nm) est implanté dans un premier temps avec des atomes d'hélium dans les conditions d'implantation 70keV-2.10¹⁶He/cm², puis implanté avec des atomes d'hydrogène dans les conditions 30keV-3.10¹⁶H/cm². On commence ainsi par l'implantation du profil le plus profond. Ce substrat source est ensuite solidarisé à un substrat cible de silice fondue (environ 1000µm) par collage direct. Un traitement thermique autour de 300° C pendant un certain temps (3h par exemple ou plus si la traitement de fragilisation est adapté) est ensuite appliqué à la structure. Ensuite, après avoir remis la structure à température ambiante au moyen d'une lame à peine insérée entre les interfaces de collage et animée d'une impulsion de mouvement (donc un choc), le détachement auto-entretenu au niveau du maximum du profil d'hydrogène mène au report de la couche mince de Si sur le substrat de silice fondue, sans casse ni dégradation de l'un ou l'autre des substrats issus de l'hétérostructure après détachement (le substrat de silice fondue comportant la couche mince de Si d'une part et le substrat de Si initial pelé de la couche mince superficielle d'autre part). La rugosité de la surface transférée, mesurée à basse fréquence par la profilométrie (de l'ordre de 14 Angstrôms RMS à basse fréquence) et en microscopie à force atomique ((de l'ordre de 75 Angstrôms en haute fréquence) de cette surface-transférée sont bien inférieures à celles qui peuvent être obtenues dans le cas de H-implanté seul (32keV-5,5.10¹⁶H/cm²) recuit à 400°°C pendant 2h et suivant le mode de détachement mécanique progressif à température ambiante (rugosité en haute fréquence de l'ordre de 90 Angstrôms RMS et de l'ordre de 40 Angstrôms à basse fréquence RMS).

### Germanium sur isolant

Les informations précédentes peuvent être généralisées au cas d'un substrat source qui est en Germanium massif, avec les paramètres de fragilisation suivants : dose 7.10¹⁶ H/cm^2 avec une énergie comprise entre 30 et 200 keV suivant l'épaisseur à transférer, et recuit de 300°C - pendant un certain temps (typiquement de 30min à 1 h soit une fenêtre opératoire de 30min).

Après ce traitement thermique spécifique à ces conditions d'implantation, la densité des micro-fissures présentes au niveau de la zone implantée est estimé entre 0,03 et 0, 035 par micron carré, leurs tailles sont de l'ordre de 7 à 8 microns carrés, et la surface ouverte par ces défauts par rapport à la surface totale de la plaque est comprise entre 25 et 32%. Les caractéristiques de la zone fragilisée peuvent paraître similaires à des caractéristiques constatées lorsque la fracture est obtenue thermiquement, mais diffèrent de celles obtenue après un traitement de fragilisation de 280°C-15min qui implique une fracture mécanique assistée auquel cas, ces valeurs sont plus faibles : par exemple, la surface ouverte par les microfissures représente moins de 10% de la surface totale de la plaque.

### Silicium sur isolant

Afin d'ouvrir la fenêtre du procédé on peut par exemple préférer implanter une dose plus importante, par exemple à 30 keV - 1.10¹⁷ H/cm² et appliquer ensuite u n traitement thermique à 350°C pendant 30min. On peut obtenir ainsi une fenêtre de 1 à 2 min d'apparition du phénomène de fracture auto entretenue, sans toutefois conduire à la fracture thermique.

### AsGa sur isolant

On applique les conditions suivantes :
- Implantation 5. 10¹⁶ at/cm² ; à 100 keV environ,
- Recuit à 250°C entre 3 et 30 minutes.

Le phénomène de fracture auto entretenue peut s'observer lorsque le recuit de fragilisation est conduit dans une fenêtre de 3 à 30 minutes

### Références

[1] K. Henttinen et al., Applied Physics Letters, Volume 16, Number 17, 24 April 2000 ; pp. 2370-2372
[2] A. Argawal et al. Applied Physics Letters, volume 72, Number 9, 2 March 1998 ; pp. 1086-1088
[3] G. F. Cerofolini et al., Materials Science and Engineering B71 - 2000, pp. 196-202

## Revendications

1. Procédé de transfert auto-entretenu d'une couche fine selon lequel:
- on prépare un substrat source,
- on implante dans ce substrat-source au moins une première espèce d'ions ou de gaz dans une première dose à une profondeur donnée par rapport à une face de ce substrat-source, cette première espèce étant apte à générer des défauts,
- on applique un raidisseur en contact intime avec le substrat-source,
- on applique un traitement thermique à ce substrat-source, à une température donnée pendant un temps donné, en sorte de créer, sensiblement à la profondeur donnée, une zone enterrée fragilisée, sans initier le détachement thermique de la couche fine,
- on applique une impulsion d'énergie à la température ambiante entre 0 et 50°C à ce substrat-source en sorte de provoquer le détachement auto-entretenu d'une couche fine délimitée entre la face et la zone enterrée fragilisée, vis-à-vis du reste du substrat-source.

2. Procédé selon la revendication 1, **caractérisé en ce que** l'on applique l'impulsion d'énergie à une petite partie seulement de la zone enterrée fragilisée.

3. Procédé selon la revendication 2, **caractérisé en ce que** l'on applique l'impulsion d'énergie sous la forme d'un apport thermique localisé.

4. Procédé selon la revendication 2, **caractérisé en ce que** l'on applique l'impulsion d'énergie sous la forme d'un apport d'un unique mouvement bref et de faible amplitude appliqué au moyen d'un outil.

5. Procédé selon la revendication 2, **caractérisé en ce que** l'on applique l'impulsion d'énergie sous la forme d'un choc en une zone périphérique de la zone enterrée fragilisée.

6. Procédé selon la revendication 1, **caractérisé en ce que** l'impulsion contrôlée d'énergie est appliquée globalement au substrat.

7. Procédé selon l'une quelconque des revendications 1 à 6, **caractérisé en ce que** le traitement thermique est conduit de telle sorte que la surface ouverte par les défauts est comprise entre 25 % et 32 % de la surface totale de la zone fragilisée dans le substrat.

8. Procédé selon la revendication 7, **caractérisé en ce que** le traitement thermique est conduit de telle sorte qu'en outre la densité des défauts est comprise entre 0,03 et 0,035 par micron carré.

9. Procédé selon la revendication 7 ou la revendication 8, **caractérisé en ce que** le traitement thermique est conduit de telle sorte qu'en outre la taille des défauts est de l'ordre de 7 à 8 microns carrés.

10. Procédé selon l'une quelconque des revendications 1 à 9, **caractérisé en ce que** le raidisseur avec lequel le substrat-source est mis en contact intime, au plus tard au moment du traitement thermique, est un substrat cible, le traitement thermique contribuant à améliorer l'énergie de collage entre ces substrats.

11. Procédé selon la revendication 10, **caractérisé en ce que** le substrat cible est en un matériau amorphe.

12. Procédé selon la revendication 10, **caractérisé en ce que** le substrat source est en silicium et le substrat cible est en silice fondue.

13. Procédé selon la revendication 10, **caractérisé en ce que** le substrat cible est un matériau monocristallin ou polycristallin.

14. Procédé selon la revendication 13, **caractérisé en ce que** le substrat cible est en silicium.

15. Procédé selon l'une quelconque des revendications 1 à 14, **caractérisé en ce que** la première espèce est de l'hydrogène.

16. Procédé selon la revendication 15, **caractérisé en ce que** la première espèce est de l'hydrogène de type H+.

17. Procédé selon la revendication 16, **caractérisé en ce que** la première espèce est implantée à une dose de l'ordre de quelques10¹⁶ H/cm².

18. Procédé selon l'une quelconque des revendications 1 à 17, **caractérisé en ce qu'**on implante en outre une seconde espèce, en une seconde dose, cette seconde espèce étant apte à occuper les défauts générés par la première espèce.

19. Procédé selon la revendication 18, caractérisé, dans le cas d'une implantation de deux espèces, en ce qu'on réalise l'implantation du profil le plus profond en premier.

20. Procédé selon la revendication 18 ou la revendication 19, **caractérisé en ce que** la seconde espèce est de l'hélium.

21. Procédé selon la revendication 20, **caractérisé en ce que** la seconde espèce est implantée à une dose de l'ordre de quelques 10¹⁶ He/cm², inférieure à la dose de la première espèce.

22. Procédé selon l'une quelconque des revendications 1 à 21, **caractérisé en ce qu'**on prépare le substrat source en un matériau choisi parmi les semi-conducteurs et les isolant, monocristallins, polycristallins ou amorphes.

23. Procédé selon la revendication 22, **caractérisé en ce qu'**on prépare le substrat source en un matériau choisi parmi les semi-conducteurs IV.

24. Procédé selon la revendication 23, **caractérisé en ce qu'**on réalise le substrat source en silicium.

25. Procédé selon la revendication 22, **caractérisé en ce qu'**on réalise le substrat en germanium.

26. Procédé selon la revendication 22, **caractérisé en ce qu'**on réalise le substrat en AsGa.

27. Procédé selon l'une quelconque des revendications 1 à 26, **caractérisé en ce que** le traitement thermique est réalisé à une température choisie dans la gamme 200°C-400°C.

28. procédé selon la revendication 27, **caractérisé en ce que** le traitement thermique est réalisé à une température choisie dans la gamme 300°C-350°C.

29. Procédé selon la revendication 27 ou la revendication 28, **caractérisé en ce que** le traitement thermique est conduit pendant environ 2 h à 5h.

30. Procédé selon la revendication 22, **caractérisé en ce qu'**on prépare le substrat source en un matériau semi-conducteur de type III-V.

31. Procédé selon la revendication 22, **caractérisé en ce qu'**on prépare le substrat source en un matériau isolant choisi dans le groupe constitué par LiNbO3 et LiTaO3.

## Patentansprüche

1. Verfahren zum selbstunterstützten Transfer einer feinen Schicht, gemäß welchem:
- man ein Ausgangssubstrat herstellt,
- man in dieses Ausgangssubstrat mindestens eine erste Ionen- oder Gasspezies in einer ersten Dosis in einer im Verhältnis zu einer Seite dieses Ausgangssubstrats bestimmten Tiefe implantiert, wobei diese erste Spezies imstande ist, Fehler zu erzeugen,
- man einen Versteifer in engem Kontakt mit dem Ausgangssubstrat anwendet,
- man dieses Ausgangssubstrat mit einer bestimmten Temperatur während einer bestimmten Zeit thermisch behandelt, um etwa in der bestimmten Tiefe eine eingeschlossene geschwächte Zone zu schaffen, ohne das thermische Ablösen der feinen Schicht einzuleiten,
- man auf dieses Ausgangssubstrat bei Raumtemperatur zwischen 0 und 50°C einen Energieimpuls anwendet, um im Verhältnis zum Rest des Ausgangssubstrats das selbstunterstützte Ablösen einer zwischen der Seite und der eingeschlossenen geschwächten Schicht begrenzten feinen Schicht zu bewirken.

2. Verfahren nach Anspruch 1, **dadurch gekennzeichnet, dass** man den Energieimpuls nur auf einen kleinen Abschnitt der eingeschlossenen geschwächten Schicht anwendet.

3. Verfahren nach Anspruch 2, **dadurch gekennzeichnet, dass** man den Energieimpuls in Form einer lokalen thermischen Zufuhr anwendet.

4. Verfahren nach Anspruch 2, **dadurch gekennzeichnet, dass** man den Energieimpuls in Form einer Zufuhr einer einzigen kurzen Bewegung mit einer geringen Amplitude anwendet, die mit einem Werkzeug erfolgt.

5. Verfahren nach Anspruch 2, **dadurch gekennzeichnet, dass** man die Energiezufuhr in Form eines Schocks in einer peripheren Zone der eingeschlossenen geschwächten Zone anwendet.

6. Verfahren nach Anspruch 1, **dadurch gekennzeichnet, dass** der kontrollierte Energieimpuls allgemein auf das Substrat angewendet wird.

7. Verfahren nach einem der Ansprüche 1 bis 6, **dadurch gekennzeichnet, dass** die thermische Behandlung derart durchgeführt wird, dass die durch die Fehler geöffnete Fläche zwischen 25 % und 32 % inklusive der Gesamtfläche der in dem Substrat geschwächten Zone beträgt.

8. Verfahren nach Anspruch 7, **dadurch gekennzeichnet, dass** die thermische Behandlung derart durchgeführt wird, dass die Dichte der Fehler ferner zwischen 0,03 und 0,035 inklusive je Quadratmikron beträgt.

9. Verfahren nach Anspruch 7 oder Anspruch 8, **dadurch gekennzeichnet, dass** die thermische Behandlung derart durchgeführt wird, dass die Größe der Fehler ferner zirka 7 bis 8 Quadratmikron beträgt.

10. Verfahren nach einem der Ansprüche 1 bis 9, **dadurch gekennzeichnet, dass** der Versteifer, mit dem das Ausgangssubstrat spätestens im Moment der thermischen Behandlung in engen Kontakt gebracht wird, ein Zielsubstrat ist, wobei die thermische Behandlung zur Verbesserung der Klebeenergie zwischen diesen Substraten beiträgt.

11. Verfahren nach Anspruch 10, **dadurch gekennzeichnet, dass** das Zielsubstrat aus einem amorphen Material ist.

12. Verfahren nach Anspruch 10, **dadurch gekennzeichnet, dass** das Ausgangssubstrat aus Silizium ist und das Zielsubstrat aus geschmolzenem Silizium ist.

13. Verfahren nach Anspruch 10, **dadurch gekennzeichnet, dass** das Zielsubstrat ein monokristallines oder polykristallines Material ist.

14. Verfahren nach Anspruch 13, **dadurch gekennzeichnet, dass** das Zielsubstrat aus Silizium ist.

15. Verfahren nach einem der Ansprüche 1 bis 14, **dadurch gekennzeichnet, dass** die erste Spezies Wasserstoff ist.

16. Verfahren nach Anspruch 15, **dadurch gekennzeichnet, dass** die erste Spezies Wasserstoff vom Typ H+ ist.

17. Verfahren nach Anspruch 16, **dadurch gekennzeichnet, dass** die erste Spezies in einer Dosis von zirka einigen 10¹⁶ H/cm² implantiert ist.

18. Verfahren nach einem der Ansprüche 1 bis 17, **dadurch gekennzeichnet, dass** man ferner eine zweite Spezies in einer zweiten Dosis implantiert, wobei diese zweite Spezies imstande ist, die von der ersten Spezies erzeugten Fehler zu besetzen.

19. Verfahren nach Anspruch 18, **dadurch gekennzeichnet, dass** man im Fall einer Implantierung von zwei Spezies die Implantierung des tiefsten Profils zuerst durchführt.

20. Verfahren nach Anspruch 18 oder Anspruch 19, **dadurch gekennzeichnet, dass** die zweite Spezies Helium ist.

21. Verfahren nach Anspruch 20, **dadurch gekennzeichnet, dass** die zweite Spezies in einer Dosis von zirka einigen 10¹⁶ He/cm² implantiert wird, die kleiner als die Dosis der ersten Spezies ist.

22. Verfahren nach einem der Ansprüche 1 bis 21, **dadurch gekennzeichnet, dass** man das Ausgangssubstrat aus einem Material herstellt, das aus den Halbleitern und den Isolatoren, monokristallinen, polykristallinen oder amorphen, ausgewählt ist.

23. Verfahren nach Anspruch 22, **dadurch gekennzeichnet, dass** man das Ausgangssubstrat aus einem Material herstellt, das aus den Halbleitern IV ausgewählt ist.

24. Verfahren nach Anspruch 23, **dadurch gekennzeichnet, dass** man das Ausgangssubstrat aus Silizium herstellt.

25. Verfahren nach Anspruch 22, **dadurch gekennzeichnet, dass** man das Substrat aus Germanium herstellt.

26. Verfahren nach Anspruch 22, **dadurch gekennzeichnet, dass** man das Substrat aus AsGa herstellt.

27. Verfahren nach einem der Ansprüche 1 bis 26, **dadurch gekennzeichnet, dass** die thermische Behandlung bei einer im Bereich 200 °C-400 °C ausgewählten Temperatur durchgeführt wird.

28. Verfahren nach Anspruch 27, **dadurch gekennzeichnet, dass** die thermische Behandlung bei einer im Bereich 300 °C-350 °C ausgewählten Temperatur durchgeführt wird.

29. Verfahren nach Anspruch 27 oder Anspruch 28, **dadurch gekennzeichnet, dass** die thermische Behandlung zirka 2 Stunden bis 5 Stunden lang durchgeführt wird.

30. Verfahren nach Anspruch 22, **dadurch gekennzeichnet, dass** man das Ausgangssubstrat aus einem Halbleitermaterial vom Typ III-V herstellt.

31. Verfahren nach Anspruch 22, **dadurch gekennzeichnet, dass** man das Ausgangssubstrat aus einem Isolationsmaterial herstellt, das aus der Gruppe ausgewählt ist, die von LiNbO3 und LiTaO3 gebildet ist.

## Claims

1. A method of self-supported transfer of a thin film, according to which:
- a source substrate is prepared;
- at least a first species of ions or gas in a first dose is implanted in that source substrate at a given depth with respect to a face of that source substrate, this first species being able to generate defects;
- a stiffener is applied in intimate contact with the source substrate;
- a heat treatment is applied to that source substrate, at a given temperature for a given time, so as to create, substantially at the given depth, a buried weakened area, without initiating the thermal splitting of the thin film,
- a pulse of energy is applied at room temperature between 0 and 50°C to this source substrate so as to provoke the self-supported splitting of a thin film delimited between the face and the buried weakened area, with respect to the remainder of the source substrate.

2. The method according to claim 1, **characterized in that** the pulse of energy is applied to a small portion only of the buried weakened area.

3. The method according to claim 2, **characterized in that** the pulse of energy is applied in the form of a localized thermal provision.

4. The method according to claim 2, **characterized in that** the pulse of energy is applied in the form of a single brief movement of small amplitude applied by means of a tool.

5. The method according to claim 2, **characterized in that** the pulse of energy is applied in the form of a shock in a peripheral area of the buried weakened area.

6. The method according to claim 1, **characterized in that** the controlled pulse of energy is applied globally to the substrate.

7. The method according to any one of claims 1 to 6, **characterized in that** the heat treatment is conducted so that the surface opened up by the defects is from 25% to 32% of the total surface of the weakened area in the substrate.

8. The method according to claim 7, **characterized in that** a heat treatment is conducted so that the density of the defects is further from 0.03 to 0.035 per square micron.

9. The method according to claim 7 or claim 8, **characterized in that** the heat treatment is conducted so that the size of the defects is further of the order of 7 to 8 square microns.

10. The method according to any one of claims 1 to 9, **characterized in that** the stiffener with which the source substrate is placed in intimate contact, at latest at the moment of the heat treatment, is a target substrate, the heat treatment contributing to improving the bonding energy between these substrates.

11. The method according to claim 10, **characterized in that** the target substrate is of an amorphous material.

12. The method according to claim 10, **characterized in that** the source substrate is of silicon and the target substrate is of fused silica.

13. The method according to claim 10, **characterized in that** the target substrate is a monocrystalline or polycrystalline material.

14. The method according to claim 13, **characterized in that** the target substrate is of silicon.

15. The method according to any one of claims 1 to 14, **characterized in that** the first species is hydrogen.

16. The method according to claim 15, **characterized in that** the first species is hydrogen of H⁺ type.

17. The method according to claim 16, **characterized in that** the first species is implanted at a dose of the order of a few 10¹⁶ H/cm².

18. The method according to any one of claims 1 to 17, **characterized in that** a second species is further implanted, at a second dose, this second species being able to occupy the defects generated by the first species.

19. The method according to claim 18, **characterized in that** in the case of implanting two species, the deepest profile is implanted first.

20. The method according to claim 18 or claim 19, **characterized in that** the second species is helium.

21. The method according to claim 20, **characterized in that** the second species is implanted at a dose of the order of a few 10¹⁶ He/cm², less than the dose of the first species.

22. The method according to any one of claims 1 to 21, **characterized in that** the source substrate is prepared from a material chosen from semiconductors and insulators, monocrystalline, polycrystalline or amorphous.

23. The method according to claim 22, **characterized in that** the source substrate is prepared from a material chosen from the semiconductors IV.

24. The method according to claim 23, **characterized in that** the source substrate is made of silicon.

25. The method according to claim 22, **characterized in that** the substrate is made of germanium.

26. The method according to claim 22, **characterized in that** the substrate is made of AsGa.

27. The method according to any one of claims 1 to 26, **characterized in that** the heat treatment is performed at a temperature chosen in the range of 200 °C to 400 °C.

28. The method according to claim 27, **characterized in that** the heat treatment is performed at a temperature chosen in the range of 300 °C to 350 °C.

29. The method according to claim 27 or claim 28, **characterized in that** the heat treatment is conducted for approximately 2 hours to 5 hours.

30. The method according to claim 22, **characterized in that** the source substrate is prepared from a semiconductor material of type III-V.

31. The method according to claim 22, **characterized in that** the source substrate is prepared from an insulator material chosen from the group consisting of LiNbO3 and LiTaO3.
